# EUROPEAN PATENT APPLICATION

(11) **EP 3 929 317 A1**
(43) Date of publication of application: **29.12.2021**
(21) Application number: 20759237.9
(22) Date of filing: 20.02.2020
(51) Int. Cl.: C22C 1/00

(54) **CORE-SHELL COMPOSITE AND METHOD FOR PRODUCING SAME**

(30) Priority: 22.02.2019 JP 2019030027
(71) Applicant: Tosoh Corporation, Yamaguchi 746-8501 (JP)
(72) Inventor: MIYAZAWA Atsushi, Tokyo 105-8623 (JP)
(74) Representative: Müller-Boré & Partner Patentanwälte PartG mbB
(86) International application number: PCT/JP2020/006762
(87) International publication number: WO 2020/171165

(57) **Abstract**

To provide a core/shell composite capable of maintaining the desired hydrogen absorbing/desorbing capability and the like against thermal history, and a method for producing it.

The core/shell composite 1 comprises a core portion 10 containing a heat resistant material selected from an inorganic oxide, a ceramic, a mineral and the like and having rigidity, and at least one layer of shell portion 20, 21 containing a hydrogen absorbing/desorbing metal covering the entire or a part of the core portion. The heat resistant material contained in the core portion 10 has a melting point higher than the highest melting point among the hydrogen absorbing/desorbing metal contained in the shell portion 20, 21. In the method for producing the core/shell composite, in production of the above core/shell composite, the core portion is covered with the shell portion by deposition in the absence of oxygen.

## Description

### TECHNICAL FIELD

The present invention relates to a core/shell composite and a method for producing it. More particularly, it relates to a core/shell composite having hydrogen absorbing/desorbing capability and having desired performance to be hardly deteriorated by thermal history, and a method for producing it.

### BACKGROUND ART

Heretofore, hydrogen storage alloys that reversibly absorb and desorb hydrogen have been known (for example, Patent Document 1), and their application to e.g. a hydrogen gas storage apparatus, a hydrogen gas forming apparatus and a secondary battery has been proposed.

### PRIOR ART DOCUMENTS

### PATENT DOCUMENT

Patent Document 1: US Patent No. 4913879

### DISCLOSURE OF INVENTION

### TECHNICAL PROBLEM

However, properties and performance of a powdery hydrogen storage alloy still should be considered. The present inventor has conducted extensive studies and as a result, has found that when such a powdery hydrogen storage alloy is used repeatedly at high temperature, its performance is deteriorated.

The present disclosure has been made under these circumstances, and its object is to provide a core/shell composite of which the desired hydrogen absorbing/desorbing capability and the like are hardly deteriorated by thermal history, and a method for producing it.

### SOLUTION TO PROBLEM

According to the present disclosure, the above object can be achieved by a core/shell composite having a predetermined core portion having heat resistance and a shell portion having hydrogen absorbing/desorbing capability in combination.

That is, the core/shell composite of the present disclosure is a core/shell composite comprising a core portion containing at least one heat resistant material selected from the group consisting of an inorganic oxide, a ceramic and a mineral and having rigidity, and at least one layer of shell portion containing a hydrogen absorbing/desorbing metal covering the entire or a part of the core portion,
wherein the heat resistant material contained in the core portion has a melting point higher than the highest melting point among the hydrogen absorbing/desorbing metal contained in the shell portion.

According to a preferred embodiment, the core/shell composite of the present disclosure has, outside the outermost layer of the shell portion, a heat resistant hydrogen permeable hull layer having both hydrogen gas permeability and heat resistance.

According to another preferred embodiment of the core/shell composite of the present disclosure, the hydrogen absorbing/desorbing metal is composed of a constituting metal capable of constituting a hydrogen storage alloy, or a hydrogen storage alloy.

According to another preferred embodiment of the core/shell composite of the present disclosure, the hydrogen absorbing/desorbing metal is composed of at least two types of constituting metal capable of constituting a hydrogen storage alloy, or at least two types of hydrogen storage alloy, and the at least two types of constituting metal or hydrogen storage alloy constitute separate layers of shell portion.

According to another preferred embodiment of the core/shell composite of the present disclosure, the shell portion containing the constituting metal or the hydrogen storage alloy having the lower melting point is sandwiched between the core portion and the shell portion composed of the constituting metal or the hydrogen storage alloy having the higher melting point, or is sandwiched between the shell portions composed of the constituting metal or the hydrogen storage alloy having the higher melting point.

According to another preferred embodiment of the core/shell composite of the present disclosure, the constituting metal constituting a hydrogen storage alloy is at least one element selected from the group consisting of titanium (Ti), manganese (Mn), zirconium (Zr), nickel (Ni), vanadium (V), lanthanum (La), palladium (Pd), magnesium (Mg), calcium (Ca), cobalt (Co), copper (Cu), iron (Fe), silver (Ag), rhodium (Rh) and aluminum (Al), or an alloy containing such an element.

The method for producing the core/shell composite of the present disclosure is a method for producing the above-described core/shell composite, wherein the core portion is covered with the shell portion by deposition in a non-oxidizing atmosphere.

According to a preferred embodiment of the method for producing the core/shell composite of the present disclosure, the deposition is carried out by sputtering, and when the core/shell composite has a plurality of layers of shell portion, the target used for formation of each of the plurality of layers is changed in an inert atmosphere such as in a stream of nitrogen, or removal of an oxide layer on the surface is carried out e.g. by bias sputtering before start of sputtering for forming each layer.

According to another preferred embodiment of the method for producing the core/shell composite of the present disclosure, the core/shell composite has, outside the outermost layer of the shell portion, a heat resistant hydrogen permeable hull layer having both hydrogen gas permeability and heat resistance, and the heat resistant hydrogen permeable hull layer is formed by formation of an oxide layer by oxidation of the hydrogen absorbing/desorbing metal contained in the outermost layer of the shell portion, or by plating.

According to still another preferred embodiment of the method for producing the core/shell composite of the present disclosure, the core/shell composite has, outside the outermost layer of the shell portion, a heat resistant hydrogen permeable hull layer having both hydrogen gas permeability and heat resistance, and the heat resistant hydrogen permeable hull layer is formed by sputtering using an oxide target or a carbide target.

### ADVANTAGEOUS EFFECTS OF INVENTION

According to the present disclosure, it is possible to provide a core/shell composite of which the desired hydrogen absorbing/desorbing capability and the like are hardly deteriorated by thermal history, and a method for producing it.

### BRIEF DESCRIPTION OF DRAWINGS

Fig. 1 is a cross sectional view illustrating an embodiment of the core/shell composite of the present disclosure.
Fig. 2 is a cross sectional view illustrating another embodiment of the core/shell composite of the present disclosure.
Fig. 3 is a cross sectional view illustrating still another embodiment of the core/shell composite of the present disclosure.
Fig. 4 is a SEM photograph of the core/shell composite (whole view) in Example 1.
Fig. 5 is a SEM photograph of the core/shell composite (partial view of the surface) in Example 1.
Fig. 6 is a SEM photograph of the core/shell composite (partial cross section) in Example 1.
Fig. 7 is a SEM photograph of a partial cross section of an example of the core/shell composite of the present invention.
Fig. 8 is a cross sectional view illustrating an example of a core/shell composite having a sea-island structure.
Fig. 9 is a cross sectional view illustrating an example of a core/shell composite having a convexoconcave layer structure.

### DESCRIPTION OF EMBODIMENTS

Now, the core/shell composite of the present disclosure will be described.

As described above, the core/shell composite of the present disclosure is a core/shell composite having a core portion and at least one layer of shell portion covering the entire or a part of the core portion.

In the core/shell composite, the heat resistant material is contained in the core portion and the hydrogen absorbing/desorbing metal is contained in the shell portion, and the melting point of the heat resistant material is higher than the highest melting point among the hydrogen absorbing/desorbing metal contained in the one layer or the plurality of layers of shell portion.

### (Embodiment 1)

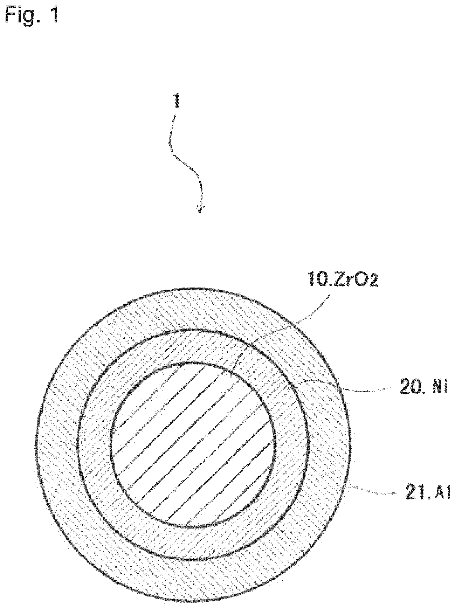

The core/shell composite of the present embodiment is a core/shell composite having a core portion and a plurality of layers of shell portion. Fig. 1 is a cross sectional view conceptually illustrating an embodiment of the core/shell composite of the present disclosure.

The core/shell composite 1 shown in Fig. 1 has a core portion 10, a first shell portion 20 and a second shell portion 21, and the entire surface of the core portion 10 is covered with the first shell portion 20. Further, in the core/shell composite 1, the entire surface of the first shell portion 20 is covered with the second shell portion 21.

In the core/shell composite 1, the core portion 10 is composed of ZrO₂, the first shell portion 20 is composed of Ni, and the second shell portion 21 is composed of Al, and melting points of these elements are, in descending order, ZrO₂: about 2,715°C, Ni: about 1,455°C and Al: about 660.3°C.

In the core/shell composite 1, the core portion 10 contains a heat resistant material, has heat resistance and rigidity, and makes it possible for the core/shell composite 1 to maintain a substantially constant shape against thermal history.

Specifically, the core portion 10 can maintain its initial shape and has hardness to such an extent as not to undergo deformation such as spontaneous bending or torsion, at a temperature from the vicinity of room temperature to the vicinity of the desired temperature (for example, the vicinity of the desired treatment temperature or reaction temperature).

On the other hand, the shell portion is, in the core/shell composite 1 according to the present embodiment, composed of two layers i.e. the first shell portion 20 and the second shell portion 21, and the first shell portion and the second shell portion contain different hydrogen absorbing/desorbing metals. In the core/shell composite 1, the shell portion contains a constituting metal (Al, Ni) capable of constituting a hydrogen storage alloy as an example of the hydrogen absorbing/desorbing metal, and has hydrogen absorbing/desorbing capability.

In the present embodiment, the thickness of each layer of shell portion is not limited so long as it is sufficiently thin relative to the size of the core portion and may, for example, be at least 10 nm and at most 1 µm, preferably at least 50 nm and at most 800 nm, and the thickness of the entire shell portion may, for example, be at least 10 nm and at most 2 µm, preferably at least 50 nm and at most 1.5 µm, more preferably at least 200 nm and at most 1 µm.

In the present embodiment, by applying heat treatment, a hydrogen storage alloy may be formed on a part of or the entire interface between the first shell portion and the second shell portion, and in the core/shell composite 1, a Ni-AI based hydrogen storage alloy may be formed on a part of or the entire interface between the first shell portion 20 and the second shell portion 21.

In the core/shell composite 1, the melting point of the heat resistant material ZrO₂ contained in the core portion 10 is higher than the melting point of the constituting metal (Ni) having a higher melting point, and accordingly even when the first shell portion 20 and the second shell portion 21 are partially melted, the core portion 10 maintains its initial shape and as a result, the core/shell composite 1 can maintain its initial state particularly in terms of macroscopic shape.

By maintaining the initial shape, reduction in the surface area (specifically the reaction surface area or the like) of the core/shell composite can be suppressed, and a decrease in performance, such as hydrogen absorbing/desorbing capability, by thermal history can be suppressed over a long term. When the core/shell composite is in the form of a powder, this effect become remarkable.

When the core/shell composite in the form of particles is macroscopically observed as an aggregate of particles, the core/shell composite according to the present embodiment is an aggregate of particles with a small change of particle size distribution by thermal history, and thus uniformity of effects in repeated treatment or operation is provided.

In the core/shell composite 1, the second shell portion located outside is composed of Al, and the first shell portion located inside thereof is composed of Ni. Even when Al is located outside in the second shell portion, so long as the temperature to which the core/shell composite 1 is exposed is in the vicinity of the melting point of Al, the initial shape of the core/shell composite 1 can be maintained.

Further, when the second shell portion located outside is composed of Ni, and the first shell portion located inside thereof is composed of Al, the melting point of the second shell portion is higher than the melting point of the first shell portion, and further, the melting point of ZrO₂ in the core portion 10 is higher than that of Ni, and thus even when the core/shell composite 1 is exposed to a considerably higher temperature than the melting point of Al, the initial shape of the core/shell composite 1 is more likely to be maintained.

### (Embodiment 2)

Now, another embodiment of the core/shell composite of the present disclosure will be described.

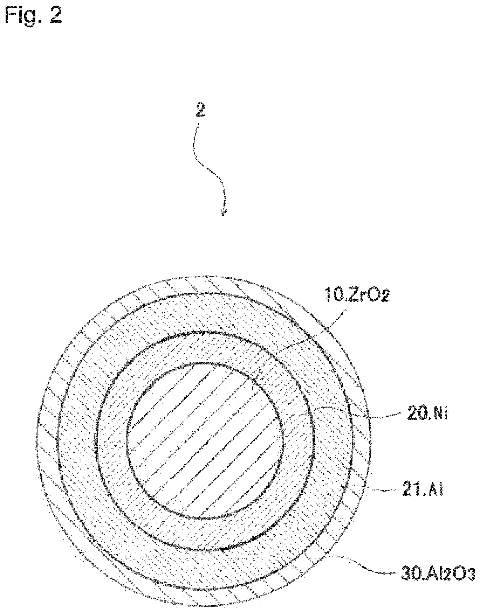

The core/shell composite of the present embodiment is a core/shell composite having the same structure as Embodiment 1, and has a heat resistant hydrogen permeable hull layer outside the outermost layer of the shell portion. Fig. 2 is a cross sectional view conceptually illustrating the core/shell composite of the present embodiment. The core/shell composite 2 shown in Fig. 2 has the same structure as Embodiment 1, and has a heat resistant hydrogen permeable hull layer outside the second shell portion 21 corresponding to the outermost layer of the shell portion. In Fig. 2, the first shell layer is composed of Ni and the second shell layer is composed of Al, and when the core/shell member has a heat resistant hydrogen permeable hull layer as in the present embodiment, such a constitution may be employed that the melting point of the outermost shell layer is lower than the melting point of the shell layer located closer to the core portion, for example, the first shell layer is composed of Ni and the second shell layer is composed of Al.

In the present embodiment, the heat resistant hydrogen permeable hull layer (hereinafter sometimes referred to as "hull layer") is one having hydrogen gas permeability, and having a melting point higher than the melting point of the outermost layer of the shell portion. In the core/shell composite 2, the hull layer 30 is composed of Al₂O₃ having a melting point of about 2,072°C, and has the above-described heat resistance and hydrogen gas permeability. The melting point of the hull layer is at most the melting point of the core portion.

Since the core/shell composite 2 has the above-described heat resistant hydrogen permeable hull layer 30, even when the core/shell composite 2 is exposed to a temperature higher than the melting point of Al constituting the second shell portion 21, the first and second shell portions are sandwiched between and fixed by the core portion 10 and the hull layer 30 having sufficient heat resistance and rigidity. This effect is considered to be one of reasons why the initial shape of the core/shell composite 2 hardly changes. Accordingly, in the core/shell composite according to the present embodiment, the melting point of the metal constituting the second shell portion may be lower than the melting point of the metal constituting the first shell portion, and since the core/shell composite has the hull layer outside the outermost layer of the shell portion, excellent effects by maintaining the initial shape can be obtained.

Further, since the hull layer 30 has hydrogen gas permeability, the function of the Ni-AI based hydrogen storage alloy formed at the interface between the first shell portion 20 and the second shell portion 21 will not substantially be impaired.

The thickness of the hull layer 30 is not limited so long as the hull layer exhibits hydrogen gas permeability and may, for example, be at least 10 nm and at most 1 µm, preferably at least 50 nm and at most 300 nm.

### (Embodiment 3)

Now, still another embodiment of the core/shell composite of the present disclosure will be described.

The core/shell composite of the present embodiment is a core/shell composite having the same structure as Embodiment 1 and has at least 3 layers, preferably at least 3 and at most 6 layers, more preferably at least 3 and at most 5 layers of shell portion. Each layer constituting the shell portion at least contains a hydrogen desorbing metal different from a hydrogen desorbing metal contained in the layer in contact therewith. Further, the core/shell composite of the present embodiment may have a heat resistant hydrogen permeable hull layer outside the outermost layer of the shell portion.

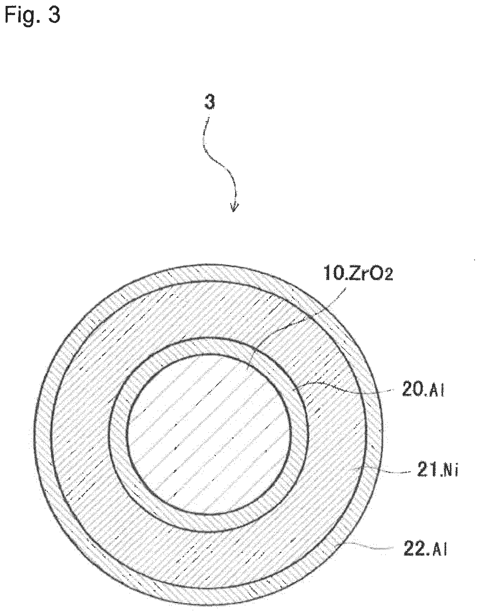

Fig. 3 is a cross sectional view conceptually illustrating the core/shell composite of the present embodiment. In Fig. 3, the core/shell composite 3 of the present embodiment has a first shell portion 20 and a third shell portion 22 composed of a constituting metal Al, and a second shell portion 21 composed of a constituting metal Ni, and the second shell portion is sandwiched between the first shell portion and the third shell portion. The core/shell composite 3 may have a heat resistant hydrogen permeable hull layer outside the third shell portion 22, in the same manner as in Embodiment 2, although not shown in Fig. 3.

The core/shell composite 3 has such a structure that the first and third shell portions 20 and 22 composed of the constituting metal Ni having the higher melting point among the constituting metals (Ni and Al) capable of constituting a hydrogen storage alloy sandwich the second shell portion 21 composed of the constituting metal having the lower melting point.

Accordingly, the core/shell composite 3 can maintain its initial shape even when subjected to heat treatment to such an extent that the second shell portion is melted.

By the outermost layer shell portion containing a metal having a high melting point, such as a case where the constating metal having the lower melting point is sandwiched by the constituting metals having the higher melting point, as in the core/shell composite 3, alloying and migration of both the constituting metals can be promoted, and the desired hydrogen storage alloy can be efficiently formed.

### <Material, shape, other structure, etc.>

Now, the material, the performance and the like of the core portion and the shell portion constituting the above-described core/shell composite will be described.

The core portion contains a heat resistant material selected from an inorganic oxide, a ceramic and a mineral, and an optional combination thereof, and the heat resistant material may, for example, be specifically zirconia (ZrO₂), alumina (A1₂O₃), silica (SiO₂), silicon carbide or zeolite, preferably at least one member selected from the group consisting of zirconia, alumina and silica, more preferably at least either one of zirconia and silica.

Zirconia contained in the core portion is preferably stabilized zirconia, more preferably zirconia stabilized by at least one member selected from the group consisting of yttria (Y₂O₃), calcia (CaO), ceria (CeO₂) and magnesia (MgO), further preferably yttria-stabilized zirconia.

With a view to improving the strength of the core portion, the yttria content of the yttria-stabilized zirconia is, as yttria to the total amount of zirconia and yttria, at least 2 mol% and at most 6 mol%, preferably at least 2 mol% and at most 4 mol%. As the crystal phase of zirconia, zirconia having tetragonal as the main phase is preferred.

From the viewpoint of operability, the core portion has a compressive strength of, for example, at least 100 MPa and at most 1200 MPa, preferably at least 850 MPa and at most 1100 MPa.

The hydrogen absorbing/desorbing metal contained in the shell portion means a metal capable of absorbing and desorbing hydrogen gas, and one or more types of element (constituting metal) capable of constituting a so-called hydrogen storage alloy, or one or more types of hydrogen storage alloy corresponds to such a metal.

The constituting metal may, for example, be an element selected from titanium (Ti), manganese (Mn), zirconium (Zr), nickel (Ni), vanadium (V), palladium (Pd), magnesium (Mg), calcium (Ca), cobalt (Co), iron (Fe), silver (Ag), rhodium (Rh) and aluminum (Al), and an optional combination thereof, or an alloy containing such an element or mixed elements. It is preferably at least one member selected from the group consisting of titanium, manganese, zirconium, nickel, magnesium, calcium, cobalt and aluminum, more preferably at least one member selected from the group consisting of nickel and aluminum, further preferably at least either of nickel and aluminum.

As the hydrogen storage alloy, conventionally known alloys may be mentioned, such as an alloy containing at least one member selected from the group consisting of calcium, palladium, magnesium, vanadium and titanium, and iron. Further, a hydrogen storage alloy having hexagonal or cubic system, called AB₅ type containing e.g. a rare earth element or AB₂ type having Laves phases may, for example, be mentioned.

Further, as a material contained in the heat resistant hydrogen permeable hull layer, the same inorganic oxide, ceramic and mineral as in the core portion may be mentioned, and a metal oxide or a ceramic is suitable, at least one member selected from the group consisting of zirconia, alumina and silica is preferred, and at least either of zirconia and alumina is more preferred.

In the above embodiment, description was made with reference to a spherical particle as the shape of individual core/shell composite, however, the shapes of the core/shell composite, the core portion and the shell portion are not necessarily limited to spherical or hollow spherical.

In addition to spherical, elliptic, scaly, columnar, plate-form, polyhedral, disk-shape and cone-form may, for example, be mentioned, and such a shape may properly be selected depending upon the treatment or operation intended for the core/shell composite, the application of the core/shell composite, etc. Macroscopically, the core/shell composite may be in the form of a powder which is an aggregate of such particles. Further, the shape may be selected depending upon e.g. the bulk density of the core/shell composite in a desired reaction, and the bulk density may, for example, be at least 1 g/cm³ and at most 8 g/cm³, preferably at least 2 g/cm³ and at most 7 g/cm³.

Further, the effects of the present disclosure will be obtained even with a structure such that the shell portion covers a part of the core portion or a part of other shell portion.

Further, as the hydrogen absorbing/desorbing metal contained in the shell portion, as described above, a plurality of types may be used, and for example, two or more types of constituting metal or hydrogen storage alloy may be used so as to form separate layers of shell portion (see, Embodiments 1 to 3).

However, it is possible to constitute one layer of shell portion e.g. by two or more types of constituting metal or the like, and the core/shell composite according to the present embodiment may, for example, be a core/shell composite having a shell portion containing both Ni and Al.

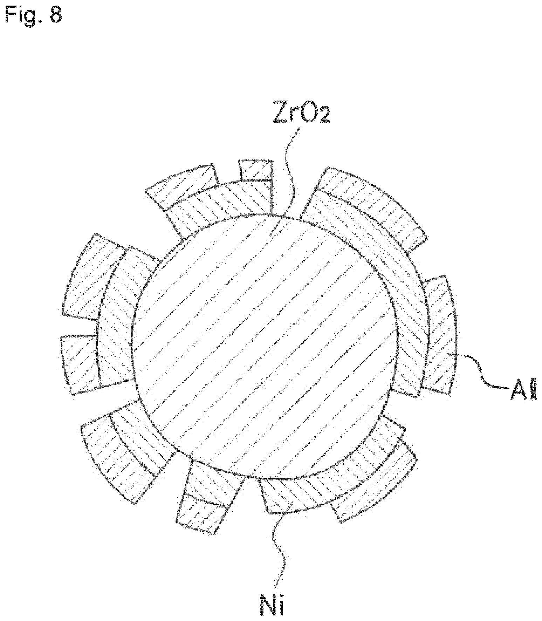

In the above case, typically, a so-called sea-island structure (Fig. 8) may be employed in which a spot composed of the first shell portion and a spot composed of the second shell portion are present on the core portion. Fig. 8 illustrates a core/shell composite having a core portion composed of ZrO₂ and on at least a part thereof, a spot composed of Ni (Ni spot) as the first shell portion and a spot composed of Al (Al spot) as the second shell portion. In such a case, the proportion of the spot composed of the first shell portion and the spot composed of the second shell portion on the core portion may suitably be changed, and the proportion may, for example, be from 1:9 to 9:1, preferably from 2:8 to 8:2.

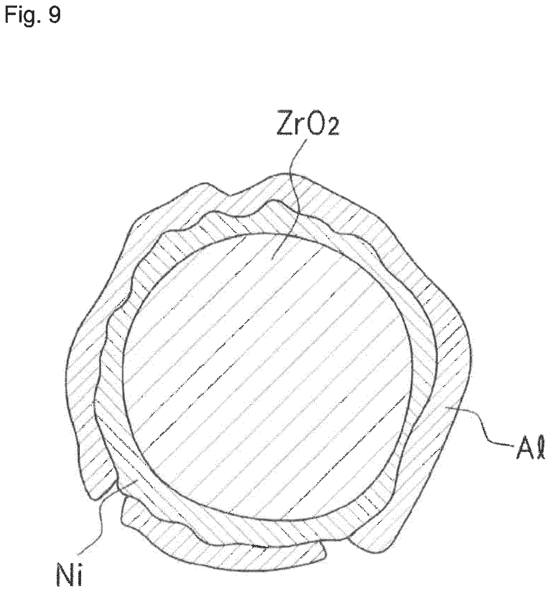

Further, the spot composed of the first shell portion and the spot composed of the second shell portion may have a difference in height (such as convexoconcave) (Fig. 9).

In the present embodiment, a part of the surface of the core portion may be exposed, however, the surface of the core portion is preferably covered with at least either of the shell portions, and the surface of the core portion is preferably not exposed.

### <Method for producing core/shell composite>

Now, the method for producing the core/shell composite of the present disclosure will be described.

The method for producing the core/shell composite of the present disclosure is to produce the above-described core/shell composite. A treatment to cover the core portion with the shell portion is carried out to produce the core/shell composite by deposition in a non-oxidizing atmosphere.

The non-oxidizing atmosphere is an atmosphere under which oxidization does not substantially proceed, and specifically, an atmosphere in which oxygen is absent, that is substantially no oxygen is present. The non-oxidizing atmosphere is preferably an inert atmosphere or a vacuum atmosphere, more preferably a vacuum atmosphere. It is further preferably a reduced pressure atmosphere of about 10⁻⁷ Torr or an atmosphere containing a very slight amount of an inert gas such as an argon gas. Inclusion of oxygen can effectively be prevented, and film deposition with high purity can be conducted, by such deposition in dry process.

As deposition, CVD or PVD, preferably sputtering may, for example, be mentioned.

In a case where sputtering is applied, and when the core/shell composite has a plurality of layers of shell portion, it is preferred that change of the target corresponding to each of the plurality of layers is conducted in a stream of nitrogen, or bias sputtering is carried out before start of sputtering after the change of the target.

By such a treatment, oxidation can be suppressed, and formation of an oxide layer e.g. between constituting metals in the shell portion can be sufficiently suppressed, and the oxide layer can be effectively removed even if formed.

In the core/shell composite of the present disclosure, when the heat resistant hydrogen permeable hull layer is formed outside the outermost layer of the shell portion, it is possible to form the heat resistant hydrogen permeable hull layer by surface treatment, by formation of an oxide layer by oxidation of the hydrogen absorbing/desorbing metal contained in the outermost layer of the shell portion, or by plating.

A desired oxide layer can be formed by adjusting e.g. the solution component. Further, by plating, a desired film thickness will readily be realized e.g. by adjusting the voltage applied or the time.

Formation of the heat resistant hydrogen permeable hull layer may be carried out also by sputtering using an oxide target or a carbide target.

### EXAMPLES

Now, the core/shell composite of the present disclosure will be described in further detail with reference to Examples and Comparative Examples, however, it should be understood that the present disclosure is by no means restricted to such specific Examples.

### (Example 1)

Using zirconia beads manufactured by Tosoh Corporation (trade name: TZ-B30) as the core, which was covered sequentially with a Ni shell layer and an Al shell layer by sputtering to obtain a core/shell composite in this Example which was substantially spherical. Sputtering was conducted in a chamber having the zirconia beads disposed, which was deaerated to vacuum. The Ni shell layer was formed using a Ni target, then the target was changed in a stream of nitrogen, and the Al shell layer was formed using an Al target.

Properties and the like of the zirconia beads used are as follows.

Composition: 3 mol% Y₂O₃-containing ZrO₂ sintered product
Compressive strength: 1050 MPa
Shape: spherical
Further, properties and the like of the zirconia beads as an aggregate (powder) are as follows.

Tap density: 3.50 g/cm³
Particle size distribution: 95% or more particles are 20 to 38 µm

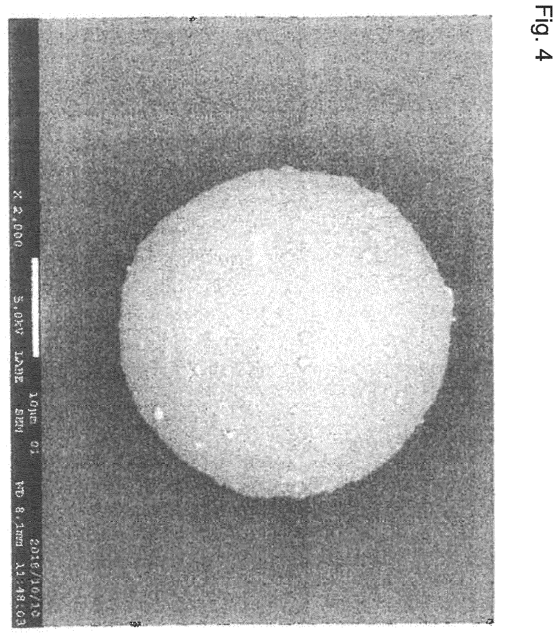

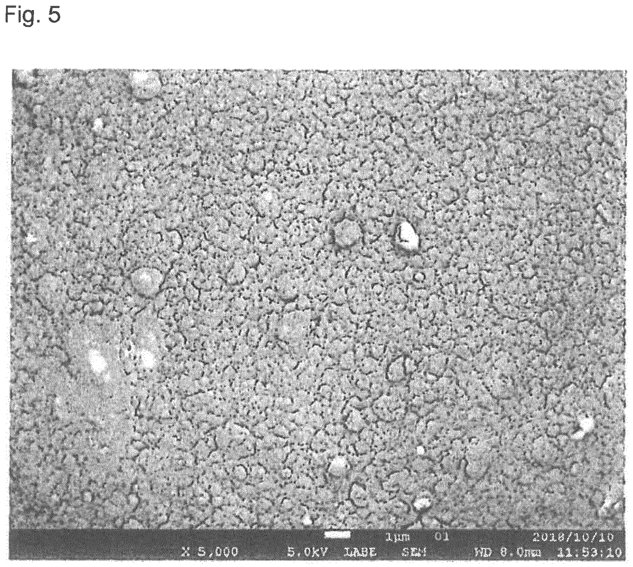

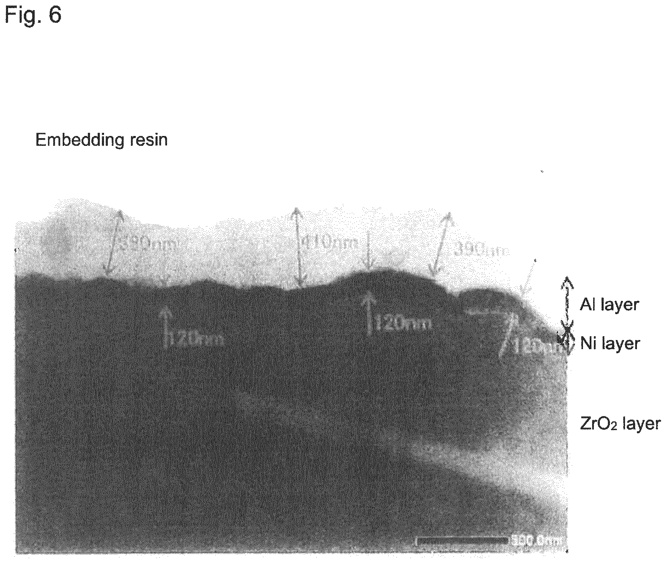

Of the obtained core/shell composite, the surface and the cross section were observed using a field emission electron microscope (trade name:JMS-7600F, manufactured by JEOL Ltd.) at an accelerating voltage of 5 kV. The obtained SEM photographs are shown in Figs. 4 to 6. Fig. 4 is a whole view, Fig. 5 is a partial view of the surface, and Fig. 6 is a partial cross section.

Further, the obtained core/shell composite was embedded in a resin and cut, and the obtained cut surface was observed using a field emission electron microscope (trade name:JMS-2100F, manufactured by JEOL Ltd.) at an accelerating voltage of 200 kV, and the elemental analysis of the cross section was conducted using an energy dispersive X-ray spectrometer (trade name: JED-2300T, manufactured by JEOL Ltd.) to determine the thickness of the shell layer. In the core/shell composite of this Example, the thickness of the Ni shell layer was about 100 nm, and the thickness of the Al shell layer was about 700 nm.

### (Examples 2-1 and 2-2)

By oxidizing the surface of the Al shell layer of the core/shell composite in Example 1 to form an Al₂O₃ layer as the outermost hull layer outside the Al shell layer thereby to obtain a core/shell composite in each Example, as shown in Fig. 2. The thickness of the Al₂O₃ layer was 80 nm in Example 2-1 and 200 nm in Example 2-2.

In the core/shell composite, the particle size of the ZrO₂ core is about 30 µm, the thickness of the Ni shell layer is about 100 nm, and the thickness of the Al shell layer is about 700 nm.

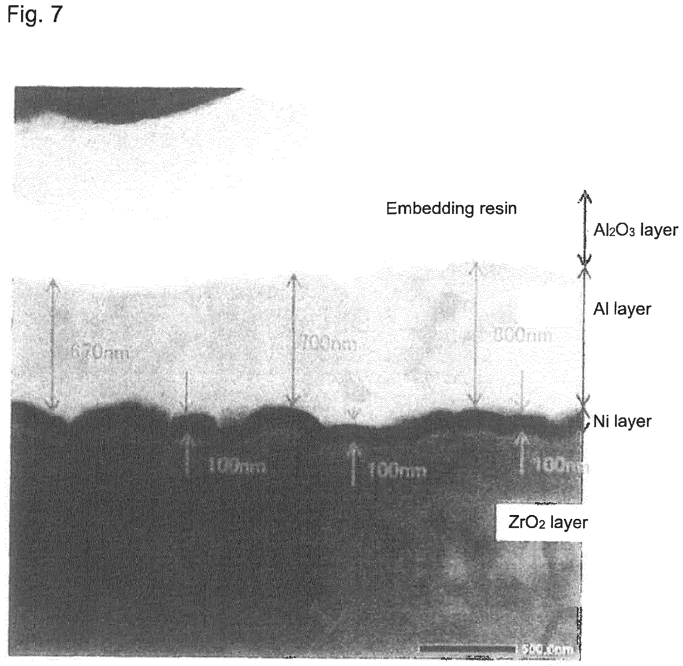

For reference, a SEM photograph of a partial cross section of the core/shell composite having such an Al₂O₃ outermost hull layer is shown in Fig. 7.

### (Comparative Example 1)

An aluminum powder, 99.8% reagent grade, having a particle size of less than 30 µm, was used as a powder in this Example.

### <Performance Evaluation>

### [Coagulation resistance]

1 g of a powder sample in each Example was weighed, heated in a nitrogen atmosphere at a heating rate of 5°C/min to 700°C, and held for one hour, whereupon the state of each powder sample was observed. As the core/shell composite in Example 1, one having a ZrO₂ diameter of 30 µm, a Ni shell layer thickness of 100 nm, and an Al shell layer thickness of 700 nm was used. The obtained results are shown in Table 1.

**[Table 1]**

| State of sample after heat treatment | |
|---|---|
| Ex. | State after heat treatment |
| Example 2-1 | No coagulation |
| Example 2-2 | No coagulation |
| Example 1 | Partial coagulation |
| Comparative Example 1 | Coagulation |

As shown in Table 1, in Examples 2-1 and 2-2 which are Examples of the present disclosure, coagulation of powder particles did not occur, and excellent heat resistance was observed. In Example 1, partial coagulation was observed, but was at a practically acceptable level.

Whereas in Comparative Example 1, coagulation was significant, thus leading to a decrease in the surface area.

The present disclosure was described with reference to embodiments and Examples, but it should be understood that the present invention is not limited to such specific description, and various modification are possible within a range of the scope of the present disclosure.

For example, in embodiments and Examples, the description was made with reference to a substantially spherical powder, but the particles may be scaly or elliptic. The material, the melting point and the like of the core portion, the shell portion and the outermost hull layer constituting the core/shell composite may properly be changed depending upon the aimed reaction and treatment.

### INDUSTRIAL APPLICABILITY

According to the present disclosure, a hydrogen absorbing/desorbing material of which the performance is hardly deteriorated by thermal history, is provided, and the core/shell composite of the present disclosure is particularly useful for fields and applications which require durability, for example, a power source for automobiles and energy storage apparatus.

The entire disclosure of Japanese Patent Application No. 2019-030027 filed on February 22, 2019 including specification, claims, drawings and summary is incorporated herein by reference in its entirety.

### REFERENCE SYMBOLS

- 1, 2, 3: core/shell composite
- 10: core portion
- 20: first shell portion
- 21: second shell portion
- 22: third shell portion
- 30: hull layer

## Claims

1. A core/shell composite comprising a core portion containing at least one heat resistant material selected from the group consisting of an inorganic oxide, a ceramic and a mineral and having rigidity, and at least one layer of shell portion containing a hydrogen absorbing/desorbing metal covering the entire or a part of the core portion,
wherein the heat resistant material contained in the core portion has a melting point higher than the highest melting point among the hydrogen absorbing/desorbing metal contained in the shell portion.

2. The core/shell composite according to Claim 1, which has, outside the outermost layer of the shell portion, a heat resistant hydrogen permeable hull layer having both hydrogen gas permeability and heat resistance.

3. The core/shell composite according to Claim 1 or 2, wherein the hydrogen absorbing/desorbing metal is composed of a constituting metal capable of constituting a hydrogen storage alloy, or a hydrogen storage alloy.

4. The core/shell composite according to any one of Claims 1 to 3, wherein the hydrogen absorbing/desorbing metal is composed of at least two types of constituting metal capable of constituting a hydrogen storage alloy, or at least two types of hydrogen storage alloy, and the at least two types of constituting metal or hydrogen storage alloy constitute separate layers of shell portion.

5. The core/shell composite according to Claim 4, wherein the shell portion containing the constituting metal or the hydrogen storage alloy having the lower melting point is sandwiched between the core portion and the shell portion composed of the constituting metal or the hydrogen storage alloy having the higher melting point, or is sandwiched between the shell portions composed of the constituting metal or the hydrogen storage alloy having the higher melting point.

6. The core/shell composite according to any one of Claims 3 to 5, wherein the constituting metal constituting a hydrogen storage alloy is at least one element selected from the group consisting of titanium (Ti), manganese (Mn), zirconium (Zr), nickel (Ni), vanadium (V), lanthanum (La), palladium (Pd), magnesium (Mg), calcium (Ca), cobalt (Co), copper (Cu), iron (Fe), silver (Ag), rhodium (Rh) and aluminum (Al), or an alloy containing such an element.

7. A method for producing the core/shell composite as defined in any one of Claims 1 to 6, wherein the core portion is covered with the shell portion by deposition in a non-oxidizing atmosphere.

8. The method for producing the core/shell composite according to Claim 7, wherein the deposition is carried out by sputtering, and
when the core/shell composite has a plurality of layers of shell portion, change of the target corresponding to each of the plurality of layers is conducted in a stream of nitrogen, or argon bombardment is carried out before start of sputtering after the change of the target.

9. The method for producing the core/shell composite according to Claim 7 or 8, wherein
the core/shell composite has, outside the outermost layer of the shell portion, a heat resistant hydrogen permeable hull layer having both hydrogen gas permeability and heat resistance, and
the heat resistant hydrogen permeable hull layer is formed by formation of an oxide layer by oxidation of the hydrogen absorbing/desorbing metal contained in the outermost layer of the shell portion, or by plating.

10. The method for producing the core/shell composite according to Claim 7 or 8, wherein
the core/shell composite has, outside the outermost layer of the shell portion, a heat resistant hydrogen permeable hull layer having both hydrogen gas permeability and heat resistance, and
the heat resistant hydrogen permeable hull layer is formed by sputtering using an oxide target or a carbide target.
